# EUROPEAN PATENT APPLICATION

(11) **EP 4 443 415 A1**
(43) Date of publication of application: **09.10.2024**
(21) Application number: 22944244.7
(22) Date of filing: 31.05.2022
(51) Int. Cl.: G09G 3/3233

(54) **DISPLAY SUBSTRATE AND DISPLAY APPARATUS**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: SHU, Xiaoqing, Beijing 100176 (CN); YANG, Huijuan, Beijing 100176 (CN); LIU, Tingliang, Beijing 100176 (CN); LIAO, Maoying, Beijing 100176 (CN); LI, Lingtong, Beijing 100176 (CN); WEI, Liheng, Beijing 100176 (CN); SHANG, Tinghua, Beijing 100176 (CN); LIU, Biao, Beijing 100176 (CN); LONG, Yixuan, Beijing 100176 (CN); XU, Peng, Beijing 100176 (CN); HUANG, Yao, Beijing 100176 (CN); WANG, Binyan, Beijing 100176 (CN)
(74) Representative: Brötz, Helmut
(86) International application number: PCT/CN2022/096446
(87) International publication number: WO 2023/230908

(57) **Abstract**

A display substrate and a display apparatus. The display substrate comprises a display area and a peripheral area. The display substrate comprises a plurality of sub-pixels, which are located on a base substrate. At least some of the sub-pixels which are located in the display area comprise light-emitting elements and pixel circuits. Each light-emitting element comprises a light-emitting functional layer, and a first electrode and a second electrode, which are located on two sides of the light-emitting functional layer in a direction perpendicular to the base substrate, wherein the first electrode is located between the light-emitting functional layer and the base substrate. Each pixel circuit comprises a drive transistor and a light emission control transistor, wherein the first electrode of the light-emitting element is electrically connected to the light emission control transistor. The display substrate further comprises a binding area, which is located in the peripheral area, wherein the binding area is located on a first side of the display area. In the same pixel circuit, a channel area of the light emission control transistor is located on the side of a channel area of the drive transistor that is away from the binding area. In the embodiments of the present disclosure, pixel circuits located in a display area are designed, thereby being conducive to reducing a lower frame of the display apparatus on the basis that a pixel space is fully utilized.

## Description

### TECHNICAL FIELD

At least one embodiment of the present disclosure relates to a display substrate and a display device.

### BACKGROUND

Presently, the active-matrix organic light-emitting diode (AMOLED) flexible screen technology becomes more and more mature, which has the characteristics of bendability, high contrast and low power consumption, thus, it has high development prospects. With the continuous development of the display technology, optimizing the display effect has become an inexorable trend, in order to improve the uniformity of display devices, some display products employ double-layer source/drain metal layer structure.

### SUMMARY

At least one embodiment of the disclosure provides a display substrate and a display device.

Embodiments of the disclosure provide a display substrate, comprising a display area and a peripheral area located on at least a side of the display area, the display substrate comprising: a base substrate; a plurality of subpixels located on the base substrate, at least part of the subpixels located in the display area comprises a light-emitting element and a pixel circuit, the light-emitting element comprising a light-emitting functional layer and a first electrode and a second electrode on both sides of the light-emitting functional layer in a direction perpendicular to the base substrate, the first electrode being located between the light-emitting functional layer and the base substrate; the pixel circuit comprising a driving transistor and a light-emitting control transistor, and the first electrode of the light-emitting element being electrically connected to the light-emitting control transistor; and a bonding area located in the peripheral area and on a first side of the display area, wherein the pixel circuit comprises an active semiconductor pattern, the active semiconductor pattern comprises a channel region and a source/drain region of each transistor; in a same pixel circuit, the channel region of the light-emitting control transistor is located on a side of the channel region of the driving transistor away from the bonding area.

For example, according to an embodiment of the disclosure, in a subpixel closest to the bonding area, an end of the active semiconductor pattern of the pixel circuit closest to the bonding area is a first end, an end of the first electrode of the light-emitting element closest to the bonding area is a second end, and the second end is closer to the bonding area than the first end.

For example, according to an embodiment of the disclosure, in a same subpixel of at least one subpixel, the channel region of the light-emitting control transistor is located on a side of a center of a light-emitting region of the light-emitting element away from the bonding area.

For example, according to an embodiment of the disclosure, the plurality of subpixels comprises a plurality of first subpixels, a plurality of second subpixels, and a plurality of third subpixels, the plurality of first subpixels and the plurality of third subpixels are alternately provided in a first direction and a second direction to form a plurality of first pixel rows and plurality of first pixel columns, the plurality of second subpixels are arranged in array along the first direction and the second direction to form a plurality of second pixel rows and plurality of second pixel columns, the plurality of first pixel rows and the plurality of second pixel rows are alternately arranged along the second direction and staggered from each other in the first direction, the plurality of first pixel columns and the plurality of second pixel columns are alternately arranged along the first direction and staggered from each other in the second direction, and the first direction and the second direction intersect with each other; a second pixel row comprising a plurality of second subpixel pairs arranged in the first direction, two second subpixels in each second subpixel pair are a first pixel block and a second pixel block, and the first pixel block and the second pixel block are alternately arranged along the first direction; the first pixel block and the second pixel block in a second pixel column are alternately arranged in the second direction; the plurality of subpixels comprises a plurality of minimum repeating units, each minimum repeating unit comprising one first subpixel, one first pixel block, one second pixel block and one third subpixel, in which the first pixel block and the first subpixel constitute a first pixel unit, the second pixel block and the third subpixel constitute a second pixel unit; in the first pixel unit, the first pixel block is located on a side of the first subpixel away from the bonding area, and in the second pixel unit, the second pixel block is located on a side of the third subpixel away from the bonding area.

For example, according to an embodiment of the disclosure, in a same subpixel of at least one of the first subpixel and the third subpixel, the channel region of the light-emitting control transistor is located on a side of a center of a light-emitting region of the light-emitting element away from the bonding area.

For example, according to an embodiment of the disclosure, the first electrode of the light-emitting element comprises a main electrode and a connecting electrode electrically connected to each other, the main electrode overlaps with the light-emitting region of the light-emitting element, the connecting electrode does not overlap with the light-emitting region, and the connecting electrode is electrically connected to the light-emitting control transistor; in the same subpixel of at least one of the first subpixel and the third subpixel, the channel region of the light-emitting control transistor is located on a side of a center of the main electrode away from the bonding area.

For example, according to an embodiment of the disclosure, for the channel region of the light-emitting control transistor and the light-emitting region of the light-emitting element of the same second subpixel, the channel region is farther away from the bonding area than the light-emitting region of the light-emitting element.

For example, according to an embodiment of the disclosure, a shape of the channel region of the driving transistor comprises a U-shape, and the U-shape opens towards a side away from the bonding area.

For example, according to an embodiment of the disclosure, a row of subpixels closest to the bonding area is the first pixel row.

For example, according to an embodiment of the disclosure, in the first pixel unit, the pixel circuit of the first pixel block and the pixel circuit of the first subpixel are arranged in the first direction; in the second pixel unit, the pixel circuit of the second pixel block and the pixel circuit of the third subpixel are arranged in the first direction.

For example, according to an embodiment of the disclosure, in the first pixel unit, the active semiconductor pattern of the first pixel block and the active semiconductor pattern of the first subpixel are symmetrically distributed with respect to a straight line located between the two active semiconductor patterns and extending in the second direction; in the second pixel unit, the active semiconductor pattern of the second pixel block and the active semiconductor pattern of the third subpixel are symmetrically distributed with respect to a straight line located between the two active semiconductor patterns and extending in the second direction.

For example, according to an embodiment of the disclosure, the display substrate further comprises: a first conductive layer located between the first electrode of the light-emitting element and the base substrate; a second conductive layer located between the first conductive layer and the first electrode of the light-emitting element, wherein the first conductive layer comprises a first connection structure and a first power signal line, the second conductive layer comprises a data line, a second connection structure and a second power signal line, and the second power signal line is electrically connected to the first power signal line; the first electrode of the light-emitting control transistor is electrically connected to the driving transistor, and the second electrode of the light-emitting control transistor is electrically connected to the first electrode of the light-emitting element through the first connection structure and the second connection structure.

For example, according to an embodiment of the disclosure, the second conductive layer further comprises a first overlap portion overlapping with a light-emitting region of at least one of the first subpixel and the third subpixel, a ratio of an area of the first overlap portion to an area of the light-emitting region is 0.6-1, and the first overlap portion is substantially symmetrically distributed relative to a straight line extending along the second direction.

For example, according to an embodiment of the disclosure, the second conductive layer further comprises a second overlap portion overlapping with a light-emitting region of the second subpixel, and the second overlap portion is substantially symmetrically distributed relative to a straight line extending in the second direction.

For example, according to an embodiment of the disclosure, in at least one of the first subpixel and the third subpixel, corners of a light-emitting region of the light-emitting element comprises a first corner and a second corner opposite to each other, and a distance from an intersection of extension lines of two sides constituting the first corner to a center of the light-emitting region is greater than a distance from an intersection of two sides or extension lines of the two sides constituting the second corner to the center of the light-emitting region; at least one of the first subpixel and the third subpixel comprises a first type subpixel and a second type subpixel; for different types of subpixels, directions from a vertex of the first corner to a vertex of the second corner are different; and in the first type subpixel and the second type subpixel, the directions from the vertex of the first corner to the vertex of the second corner direction are a first orientation and a second orientation, respectively, and the first orientation and the second orientation are opposite to each other.

For example, according to an embodiment of the disclosure, at least one of the first subpixel and the third subpixel further comprises a third type subpixel and a fourth type subpixel; for the third type subpixel and the fourth type subpixel, directions from the vertex of the first corner to the vertex of the second corner direction are a third orientation and a fourth orientation, respectively, the third orientation and the fourth orientation are opposite to each other, and the first orientation intersects with the third orientation.

For example, according to an embodiment of the disclosure, at least one of the first subpixel and the third subpixel is a red subpixel configured to emit red light, the other one of the first subpixel and the third subpixel is a blue subpixel configured to emit blue light, and the second subpixel is a green subpixel configured to emit green light.

Embodiments of the disclosure provide a display device comprising a display substrate according to any item as mentioned above.

### BRIEF DESCRIPTION OF DRAWINGS

In order to clearly illustrate the technical solution of the embodiments of the disclosure, the drawings of the embodiments will be briefly described in the following; it is obvious that the described drawings are only related to some embodiments of the disclosure and thus are not limitative of the disclosure.
Fig. 1 is a schematic diagram illustrating a pixel arrangement structure in a substrate;
Fig. 2 is a schematic diagram of a display area boundary and a lower pad area in the display substrate illustrated in Fig. 1;
Fig. 3 is an enlarged view of Area B illustrated in Fig. 2;
Fig 4 is a schematic diagram of a partial pixel arrangement structure on a display substrate provided according to an embodiment of the present disclosure;
Fig. 5 is a schematic diagram of an adjacent part between a display area and a peripheral area of the display substrate illustrated in Fig. 4;
Fig. 6 is an enlarged view illustrating region C in the display substrate illustrated in Fig. 5;
Fig. 7 is a schematic diagram of a partial cross-sectional structure taken along the CC' line illustrated in Fig. 6;
Fig. 8 is an equivalent diagram of a pixel circuit provided according to the embodiment of the present disclosure;
Fig. 9A is a partial structure diagram of an active semiconductor pattern in the display substrate illustrated in Fig. 4;
Fig. 9B is a partial structure diagram of an active semiconductor pattern in the display substrate illustrated in Fig. 1;
Fig. 10A is a partial structure diagram of a first conductive layer provided according to an embodiment of the present disclosure;
Fig. 10B is a partial structure diagram of a second conductive layer provided according to an embodiment of the present disclosure;
Fig. 10C is a schematic diagram illustrating a stack structure of an active semiconductor pattern, a first conductive layer, and a second conductive layer provided according to an embodiment of the present disclosure;
Fig. 10D is a schematic diagram illustrating a stack structure of an active semiconductor pattern, a second conductive layer, and a first electrode of a light-emitting element provided according to an embodiment of the present disclosure;
Fig. 10E is a schematic structure diagram of a first electrode of a light-emitting element provided according to an embodiment of the disclosure;
Fig. 11A and Fig. 11E are schematic diagrams of pixel arrangements according to different examples in embodiments of the present disclosure.

### DETAILED DESCRIPTION

In order to make objects, technical details and advantages of the embodiments of the disclosure apparent, the technical solutions of the embodiment will be described in a clearly and fully understandable way in connection with the drawings related to the embodiments of the disclosure. It is obvious that the described embodiments are just a part but not all of the embodiments of the disclosure. Based on the described embodiments herein, those skilled in the art can obtain other embodiment(s), without any inventive work, which should be within the scope of the disclosure.

Unless otherwise specified, the technical terms or scientific terms used in the disclosure shall have normal meanings understood by those skilled in the art. The words "first", "second" and the like used in the disclosure do not indicate the sequence, the number or the importance but are only used for distinguishing different components. The word "comprise", "include" or the like only indicates that an element or a component before the word contains elements or components listed after the word and equivalents thereof, not excluding other elements or components.

The features, such as "vertical" and "identical" as used in the embodiments of the present disclosure include features, such as "vertical" and "identical" in the strict sense, as well as "substantially vertical", "substantially identical", and the like containing certain errors, which expresses being within the acceptable deviation range for a particular value determined by those skilled in the art taking into account the measurement and the error associated with the measurement of a particular quantity (i.e., the limitation of the measurement system). The term "center" in the embodiment of the present disclosure may include a location strictly located in the center of the geometry and a position located in a roughly central area around the center of geometry. For example, the term "substantially" can express a value within one or more standard deviations, or within 10% or 5% of the value.

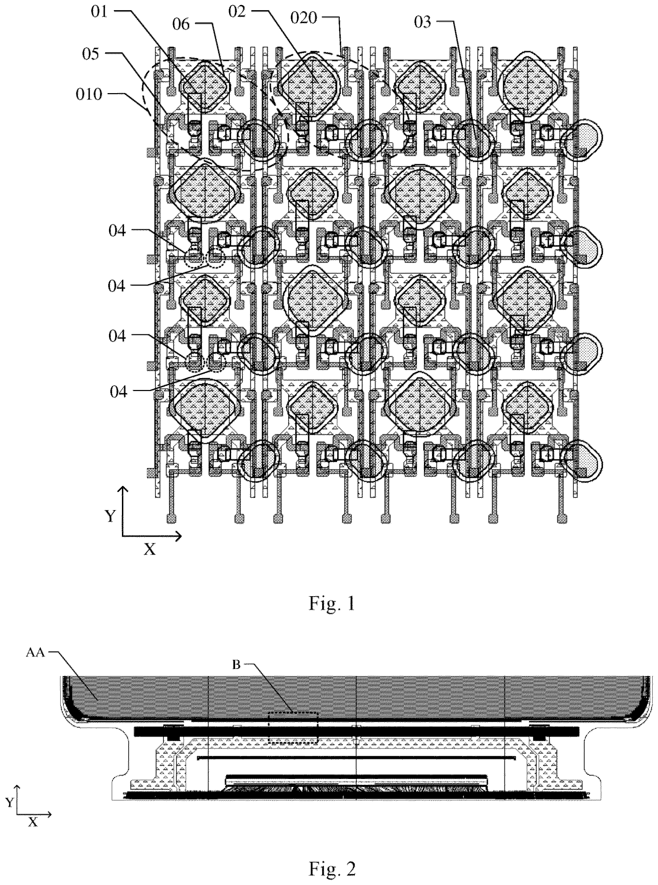

Fig. 1 is a schematic diagram illustrating a pixel arrangement structure in a display substrate. As shown in Fig. 1, the display substrate includes a display area, the display area includes a plurality of subpixels, such as a red subpixel 01 configured to emit red light, a blue subpixel 02 configured to emit blue light, and a green subpixel 03 configured to emit green light. At least a part of the subpixel includes a light-emitting element and a pixel circuit driving the light-emitting element. The light-emitting element comprises an anode 06, a light-emitting functional layer, and a cathode stacked sequentially. The pixel circuit comprises a plurality of transistors and at least one capacitor. The display substrate includes an active semiconductor pattern 05, and the active semiconductor pattern 05 includes a channel region and a source/drain region of each transistor.

As shown in Fig. 1, a plurality of subpixels includes a plurality of minimum repeating units, each of which comprises a red subpixel 01, a blue subpixel 02, and two green subpixels 03. In each minimum repeating unit, the red subpixel 01 and one green subpixel 03 constitute a first pixel unit 010, the blue subpixel 02 and another green subpixel 03 constitute a second pixel unit 020, as in each minimum repeating unit, the red subpixel 01 and the blue subpixel 02 are shared by the first pixel unit 010 and the second pixel unit 020, respectively.

As shown in Fig. 1, in the first pixel unit 010, the pixel circuit of the red subpixel 01 and the pixel circuit in the green subpixel 03 are arranged in the X direction; in the second pixel unit 020, the pixel circuits in the blue subpixel 02 and green subpixel 03 are arranged in the X direction.

Taking the direction pointed by the arrow in the Y direction in Fig. 1 as the upward direction, and the arrow in the X direction as the right direction, Fig. 1 shows that the green subpixel 03 in the first pixel unit 010 is located at the lower right of the red subpixel 01, the green subpixel 03 in the second pixel unit 020 is located at the lower right of the blue subpixel 02, and the anode 06 of the light-emitting element of each subpixel is electrically connected to a position 04 in the active semiconductor pattern 05 (such as the source electrode or the drain electrode of the light-emitting transistor).

Using the pixel borrowing relationship shown in Fig. 1, both the anodes 06 of the red subpixel 01 and the blue subpixel 02 need to be extended downward to be electrically connected with the position 04 in the active semiconductor pattern 05 (such as the source electrode or the drain electrode of the light-emitting control transistor). In this case, the part of the anode in the subpixel for being electrically connected with the position 04 of the active semiconductor pattern 05 is located below the light-emitting region of the subpixel.

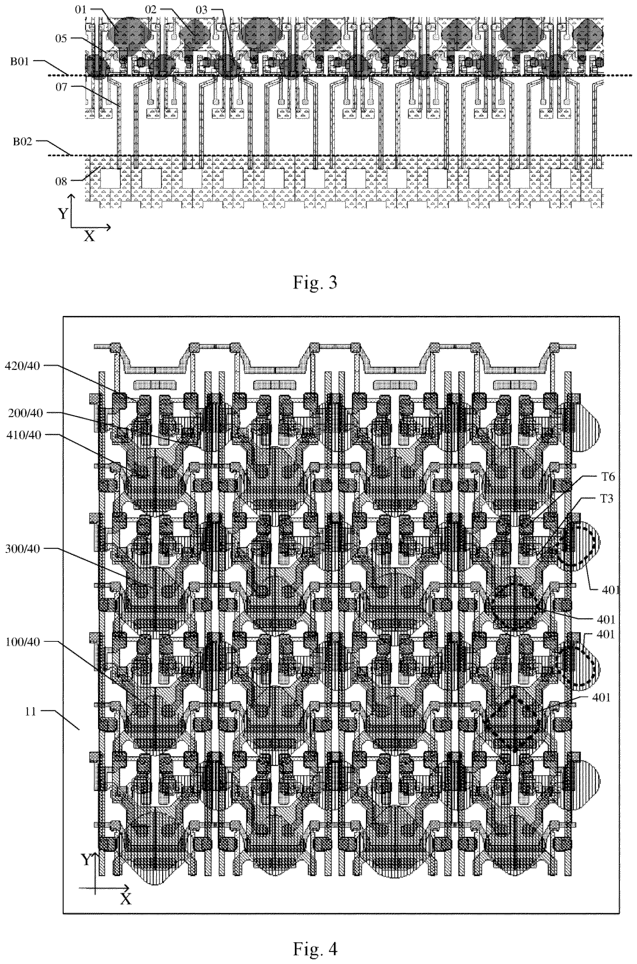

Fig. 2 is a schematic diagram of a display area boundary and a lower pad area in the display substrate shown in Fig. 1, and Fig. 3 is an enlarged view of the Area B shown in Fig. 2. As shown in Fig. 2 and Fig. 3, the display substrate further comprises a pad region located on one side of the display area AA, such as the lower pad area located below the display area AA. The lower pad area may include a lower border, the lower pad area includes a bonding area, and the bonding area is located in the lower pad area near the display area AA.

As shown in Fig. 2 and Fig. 3, the row of subpixels closest to the bonding area is a row of green subpixels 03.

As shown in Fig. 3, the display substrate further comprises a conductive layer 07, the conductive layer 07 is located between the anode 06 of the light-emitting element and the active semiconductor pattern 05, for example, the conductive layer 07 may include a power signal line to transmit a VDD signal, and the conductive layer 07 may further include a data line to transmit a data signal. The lower pad area is provided with a signal transmission line 08 electrically connected to the power signal line.

As shown in Fig. 3, using the pixel borrowing relationship shown in Fig. 1, at least part of the subpixels has an anode which has a part for electrically connecting the active semiconductor pattern 05 and extending to the side close to the lower pad region, and the active semiconductor pattern 05 electrically connected to the anode of the subpixel which is the one closest to the lower pad region comprises a portion located on the side of the boundary B01 of the display area AA close to the boundary B02 of the signal source 08. In order to meet the pixel circuit design of the subpixel closest to the lower pad area, it is necessary to set a larger spacing between the boundary B01 and the boundary B02, which easily leads to the need to retain a larger size of the lower pad area, that is, the lower border of the display device is larger in the Y direction.

The embodiment of the present disclosure provides a display substrate and a display device. The display substrate includes a display area and a peripheral area located on at least one side of the display area. The display substrate comprises a plurality of subpixels located on the base substrate, at least part of the subpixels located in the display area comprises a light-emitting element and a pixel circuit, the light-emitting element comprises a light-emitting functional layer and a first electrode and a second electrode on both sides of the light-emitting functional layer in a direction perpendicular to the base substrate, the first electrode is located between the light-emitting functional layer and the base substrate; The pixel circuit includes a driving transistor and a light-emitting control transistor, the first electrode of the light-emitting element is electrically connected to the light-emitting control transistor, and the display substrate further comprises a bonding area located in the peripheral area, and the bonding area is only located on one side of the display area. In a pixel circuit, the light-emitting control transistor is located on a side of the driving transistor away from the bonding area. In the embodiment of the present disclosure, by designing the pixel circuit located in the display area, on the basis of making full use of the pixel space, it is advantageous in narrowing the lower border of the display device.

The display substrate and display device provided in the embodiment of the present disclosure are described below in conjunction with the accompanying drawings.

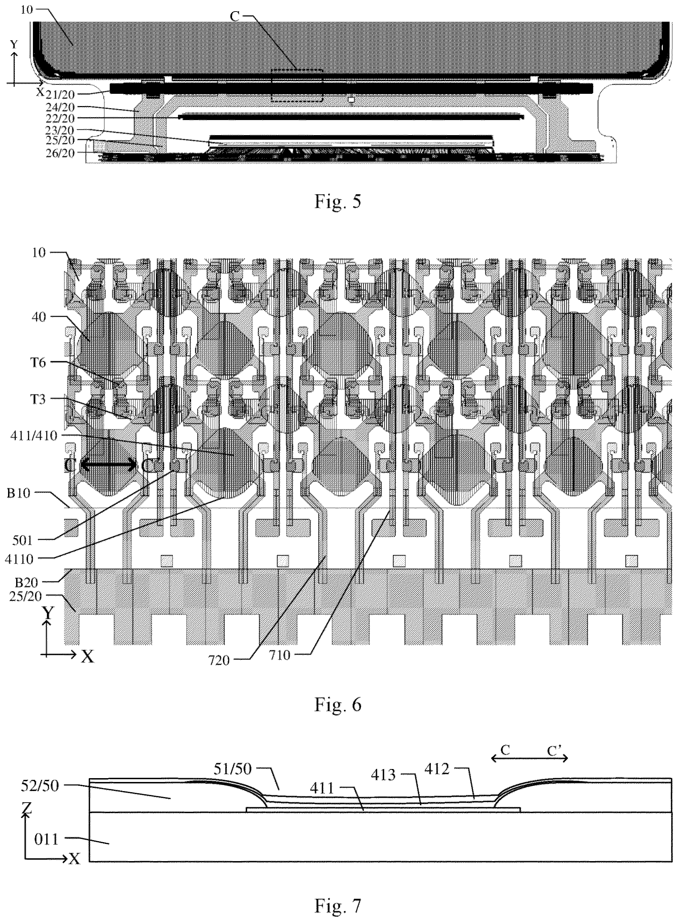

Fig. 4 is a schematic diagram of a partial pixel arrangement structure on a display substrate provided according to an embodiment of the present disclosure, Fig. 5 is a schematic diagram of an adjacent portion between a display area and a peripheral area of the display substrate shown in Fig. 4, Fig. 6 is an enlarged view of the region C in the display substrate shown in Fig. 5, and Fig. 7 is a schematic diagram of a partial cross-sectional structure taken along line CC' shown in Fig. 6.

As shown in Fig. 4 to Fig. 7, the display substrate includes a display area 10 and a peripheral area 20 located on at least one side of the display area 10. For example, the display area 10 is a region for displaying in the display substrate, and the peripheral area 20 is a region located in the periphery of the display area and being not using for displaying in the display substrate.

As shown in Fig. 4 to Fig. 7, the display substrate includes a base substrate 11 and a plurality of subpixels 40 located on the base substrate 11. For example, at least part of a plurality of subpixels 40 is located in the display area 10. For example, at least part of the subpixels 40 located in the display area 10 are used for image displaying. For example, all the subpixels 40 located in the display area 10 are used for the image displaying.

As shown in Fig. 4 to Fig. 7, at least some subpixels 40 located in the display area 10 include a light-emitting element 410 and a pixel circuit 420, the light-emitting element 410 includes a light-emitting functional layer 413 and a first electrode 411 and a second electrode 412 on both sides of the light-emitting functional layer 413 in a direction perpendicular to the base substrate 11, the first electrode 411 is located between the light-emitting functional layer 413 and the base substrate 11.

For example, as shown in Fig. 7, the display substrate further comprises a pixel-definition pattern 50, the pixel-definition pattern 50 is located on the side of the first electrode 411 of the light-emitting element 410 away from the base substrate 11, and the pixel-definition pattern 50 includes a plurality of openings 51 and a definition portion 52 around the plurality of openings 51, and a plurality of light-emitting elements 410 are at least partially located in the plurality of openings 51. Fig. 7 schematically illustrates that the first electrode 411 of the light-emitting element 410 is provided with a structural layer 011 on one side away from the second electrode 412, the structural layer 011 may include a base substrate, a layer where an active semiconductor pattern is located, a layer where the gate lines are located, a layer where the data lines are located, a plurality of insulation layers, and so on.

For example, the definition portion 52 is a structure of defining the openings 51. For example, the material of the definition portion 52 may include polyimide, acrylic or polyethylene terephthalate and the like.

For example, the openings 51 of the pixel definition pattern 50 are configured to limit a light-emitting region 401 of the light-emitting element 410. For example, the light-emitting elements 410 of a plurality of subpixels 40 may be provided in one-to-one correspondence with a plurality of openings 51. For example, the light-emitting element 410 may include a portion located in the opening 51, and a portion that overlaps the definition portion 52 in the direction perpendicular to the base substrate 11.

For example, the opening 51 of the pixel definition pattern 50 is configured to expose the first electrode 411 of the light-emitting element 410, and at least a part of the first electrode 411, which is exposed, is in contact with the light-emitting functional layer 413 of the light-emitting element 410. For example, at least a part of the first electrode 411 is located between the definition portion 52 and the base substrate 11. For example, when the light-emitting functional layer 413 is located in the opening 51 of the pixel-definition pattern 50, the first electrode 411 and the second electrode 220 on both sides of the light-emitting functional layer 413 are capable of driving the light-emitting functional layer 413 in the opening 51 of the pixel-definition pattern 50 to emit light. For example, the light-emitting region 401 as mentioned above may refer to the effective light-emitting region of the light-emitting element, the shape of the light-emitting region 401 refers to a two-dimensional shape, for example, the shape of the light-emitting region 401 may be the same as the shape of the openings 51 of the pixel-definition pattern 50. For example, the opening 51 of the pixel definition pattern 50 may have a shape with a small size near the base substrate 11 and a larger size away from the base substrate 11. For example, the shape of the light-emitting region 401 approximately has the same size and shape as the opening 51 of the pixel-definition pattern 50 near the base substrate 11.

For example, the first electrode 411 may be an anode, and the second electrode 412 may be a cathode. For example, the cathode can be formed from a material with high conductivity and low work function, for example, the cathode can be made of metallic materials. For example, the anode can be formed from a conductive material with a high work function.

As shown in Fig. 4 to Fig. 7, the pixel circuit 420 includes a driving transistor T3 and a light-emitting control transistor T6, the first electrode 411 of the light-emitting element 410 is electrically connected to the light-emitting control transistor T6.

As shown in Fig. 4 to Fig. 7, the display substrate further comprises a bonding area 21 located in the peripheral area 20, and the bonding area 21 is located on a first side of the display area 10. For example, the bonding area 21 is located only on one side of the display area 10. For example, the bonding area 21 is located on a side of the display area 10 in the Y direction. For example, with the Y direction arrow in Fig. 5 referring to the upward direction, the bonding area 21 is located below the display area 10.

As shown in Fig. 4 to Fig. 7, in the same pixel circuit 420, the light-emitting control transistor T6 is located on a side of the driving transistor T3 away from the bonding area 21. For example, the pixel circuit 420 includes an active semiconductor pattern, the active semiconductor pattern includes a channel region and a source/drain region of each transistor, the channel region of the light-emitting control transistor T6 is located on a side of the channel region of the driving transistor T3 away from the bonding area 21. For example, the gate electrode of the light-emitting control transistor T6 is located on a side of the gate electrode of the driving transistor T3 away from the bonding area.

For example, the driving transistor T3 in each pixel circuit 420 is located between the light-emitting control transistor T6 and the bonding area 21. For example, in each pixel circuit 420, the driving transistor T3 is located below the light-emitting control transistor T6. For example, in the same pixel circuit 420, the channel region of the driving transistor T3 is located between the channel region of the light-emitting control transistor T6 and the bonding area 21. For example, in each pixel circuit 420, the channel region of the driving transistor T3 is located below the channel region of the light-emitting control transistor T6.

By designing the pixel circuit located in the display area, the light-emitting control transistor in the pixel circuit is disposed on the side of the driving transistor away from the bonding area, which may be conducive to improving the flatness of the first electrode of the subpixel and narrowing the lower border of the display device on the basis of making full use of the pixel space.

For example, as shown in Fig. 5, the peripheral area 20 where the bonding area 21 is located includes a pad region, the pad region includes a bonding area 21, CT (Cell Test) 22, COP (IC On Panel) 23, a first signal transmission line 24 (such as transmitting VSS signals), a second signal transmission line 25 (such as transmitting VDD signals) and FOP (FPC On Panel) 26 and the like.

For example, the bonding area 21 is configured to bond with at least one of a data driver chip and a gate driver chip. For example, the bonding area 21 may include a signal input pad and a transmission line electrically connected to the signal input pad, for example, a data line may be electrically connected to the signal input pad through the transmission line. For example, the bonding area 21 may include a bendable area, the structure described above, such as the CT (Cell Test) 22, COP (IC On Panel) 23 and FOP (FPC On Panel) 26, may be bent to the back of the display substrate which is not used for displaying. For example, the light-emitting element is located on the first side of the display substrate (such as the front side), the CT (Cell Test) 22, COP (IC On Panel) 23 and FOP (FPC On Structures such as Panel) 26 can be bent to the second side of the display substrate (such as the back side).

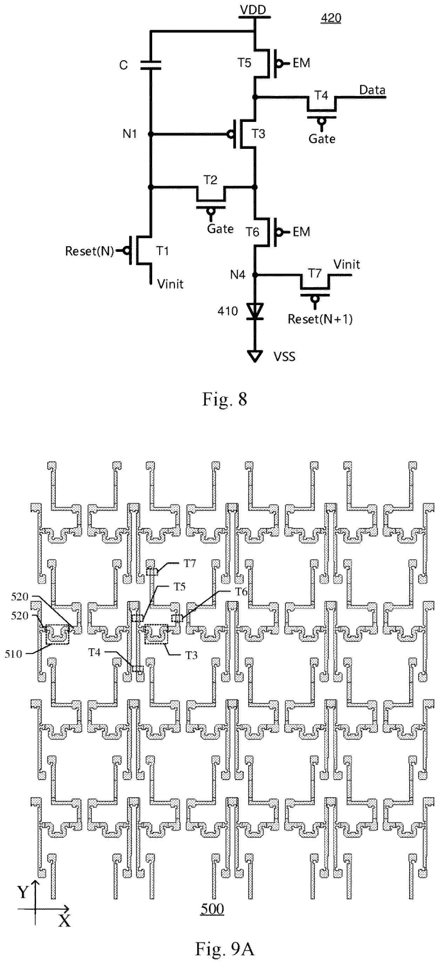

Fig. 8 is an equivalent diagram of a pixel circuit provided according to an embodiment of the present disclosure. For example, as shown in Fig. 8, the light-emitting control transistor T6 in the pixel circuit 420 may be a first light-emitting control transistor T6, the pixel circuit 420 further comprises a second reset transistor T1, a second light-emitting control transistor T5, a data writing transistor T4, a threshold compensation transistor T2, a first reset control transistor T7, and a storage capacitor C.

For example, the display substrate further includes reset power signal lines, scanning signal lines, power signal lines, reset control signal lines, light-emitting control signal lines, and data lines.

For example, the first electrode of the threshold compensation transistor T2 is electrically connected to the first electrode of the driving transistor T3, and the second electrode of the threshold compensation transistor T2 is electrically connected to the gate electrode of the driving transistor T3. The first electrode of the first reset control transistor T7 is electrically connected to the reset power signal line to receive the reset signal Vinit, and the second electrode of the first reset control transistor T7 is electrically connected to the first electrode of the light-emitting element 410 (i.e., node N4); the first electrode of the data writing transistor T4 is electrically connected to the second electrode of the driving transistor T3, the second electrode of the data writing transistor T4 is electrically connected to the data line to receive the data signal Data, and the gate electrode of the data writing transistor T4 is electrically connected to the scanning signal line to receive the scanning signal Gate. The first electrode of the storage capacitor C is electrically connected to the power signal line, and the second electrode of the storage capacitor C is electrically connected to the gate electrode of the driving transistor T3. The gate electrode of the threshold compensation transistor T2 is electrically connected to the scanning signal line to receive the compensation control signal. The gate electrode of the first reset transistor T7 is electrically connected to the reset control signal line to receive the reset control signal Reset(N+1). The first electrode of the second reset transistor T1 is electrically connected to the reset power signal line to receive the reset signal Vinit, the second electrode of the second reset transistor T1 is electrically connected to the gate electrode of the driving transistor T3, and the gate electrode of the second reset transistor T1 is electrically connected to the reset control signal line to receive the reset control signal Reset(N). The gate electrode of the first light-emitting control transistor T6 is electrically connected to the light-emitting control signal line to receive the light-emitting control signal EM. The first electrode of the first light-emitting control transistor T6 is electrically connected to the first electrode of the driving transistor T3, and the second electrode of the first light-emitting control transistor T6 is electrically connected to the first electrode of the light-emitting element 410. The first electrode of the second light-emitting control transistor T5 is electrically connected to the power signal line to receive the first power signal VDD, the second electrode of the second light-emitting control transistor T5 is electrically connected to the second electrode of the driving transistor T3, the gate electrode of the second light-emitting control transistor T5 is electrically connected with the light-emitting control signal line to receive the light-emitting control signal EM, and the second electrode of the light-emitting element 410 is connected to the voltage terminal VSS. The above power signal line refers to the signal line of outputting the voltage signal VDD, which can be connected to a voltage source to output a constant voltage signal, such as a positive voltage signal.

For example, the scanning signal and the compensation control signal can be the same, that is, the gate electrode of the data writing transistor T3 and the gate electrode of the threshold compensation transistor T2 can be electrically connected to the same signal line to receive the same signal, which can reduce the number of signal lines. For example, the gate electrode of the data writing transistor T3 and the gate electrode of the threshold compensation transistor T2 can also be electrically connected to different signal lines respectively, that is, the gate electrode of the data writing transistor T3 is electrically connected to the first scanning signal line, and the gate electrode of the threshold compensation transistor T2 is connected to the second scanning signal line, and the signals transmitted by the first scanning signal line and the second scanning signal line can be the same or different, so that the gate electrode of the data writing transistor T3 and the gate electrode of the threshold compensation transistor T2 can be controlled separately, which can increase the flexibility of pixel circuitry control.

For example, the light-emitting control signals being input into the first light-emitting control transistor T6 and the second light-emitting control transistor T5 may be the same, that is, the gate electrode of the first light-emitting control transistor T6 and the gate electrode of the second light-emitting control transistor T5 may be electrically connected to the same signal line to receive the same signal, reducing the number of signal lines. For example, the gate electrode of the first light-emitting control transistor T6 and the gate electrode of the second light-emitting control transistor T5 may also be electrically connected to different light-emitting control signal lines, and the different light-emitting control signal lines may transmit the same or different signals.

For example, the reset control signals being input into the first reset transistor T7 and the second reset transistor T1 can be the same, that is, the gate electrode of the first reset transistor T7 and the gate electrode of the second reset transistor T1 can be electrically connected to the same signal line to receive the same signal, reducing the number of signal lines. For example, the gate electrode of the first reset transistor T7 and the gate electrode of the second reset transistor T1 can also be electrically connected to different reset control signal lines, in which case the signals on different reset control signal lines may or may not be the same.

For example, as shown in Fig. 8, when the display substrate works, in the first stage of the image display, the second reset transistor T1 is turned on, so that the voltage of the N1 node is initialized. In the second stage of the image display, the data Data is stored in the N1 node by the data writing transistor T4, the driving transistor T3, and the threshold compensation transistor T2. In the third light-emitting stage, the second light-emitting control transistor T5, the driving transistor T3 and the first light-emitting control transistor T6 are all turned on, and the light-emitting element 410 is forwardly conducted to emit light.

It should be noted that, in the embodiment of the present disclosure, in addition to the 7T1C (i.e., seven transistors and a capacitor) structure shown in Fig. 8, each pixel circuit may be other structures including different numbers of transistors, such as 7T2C structure, 6T1C structure, 6T2C structure or 9T2C structure, the present disclosure embodiment is not limited thereto. The equivalent diagram of the pixel circuit in the substrate in Fig. 1 can be the same as the equivalent diagram of the pixel circuit shown in Fig. 8.

Fig. 9A shows a partial structure diagram of the active semiconductor pattern in the display substrate shown in Fig. 4. For example, as shown in Fig. 4 to Fig. 7 and Fig. 9A, the pixel circuit 420 includes an active semiconductor pattern 500, the active semiconductor pattern 500 includes a channel region 510 and a source/drain region 520 of each transistor. For example, the source/drain region 520 may include a source region and a drain region.

For example, Fig. 9A schematically shows an active semiconductor pattern 500 may be formed by patterning a semiconductor material. The active semiconductor pattern 500 may be used to form the active layers of the driving transistor T3, the data writing transistor T4, the second light-emitting control transistor T5, the first light-emitting control transistor T6 and the first reset control transistor T7 to form the channel regions of these transistors. The active semiconductor pattern 500 includes an active layer pattern (channel region) and a doped region pattern (source/drain region) of each subpixel of these transistors, and the active layer pattern and the doped region pattern of these transistors in the same pixel circuit are provided integrally.

For example, the active semiconductor pattern 500 may be made of amorphous silicon, polysilicon, oxide semiconductor materials, etc. It should be noted that the source region and the drain region described above may be regions doped with n-type impurities or p-type impurities.

For example, the active semiconductor pattern 500 is provided with a metal layer on one side away from the base substrate, such as a gate metal layer, the metal layer comprises the scanning signal line, the reset control signal line, the light-emitting control signal line, and the gate electrodes of the driving transistor T3, the data writing transistor T4, the second light-emitting control transistor T5, the first light-emitting control transistor T6, and the first reset control transistor T7. In Fig. 9A, each dashed rectangular frame shows the portions of the metal layer and the active semiconductor pattern 500 overlapping each other to be the channel regions 510 of the various transistors, in which the active semiconductor pattern 500 on two sides of each channel region 510 is turned into conductor by ion doping and other processes to be the first and second electrodes of each transistor (i.e., the source/drain region 520 described above). The source and drain electrodes of the transistors can be symmetrical in structure, so its source electrode and drain electrode can be physically indistinguishable. In an embodiment of the present disclosure, in order to distinguish the transistor, in addition to the gate electrode as the control electrode, one of the electrodes is directly described as the first electrode, the other one of the electrodes is directly described as the second electrode, so that the first electrodes and the second electrodes of all or part of the transistors in the embodiment of the present disclosure are exchangeable as needed.

For example, as shown in Fig. 5 and Fig. 9A, the shape of the channel region of the driving transistor T3 includes a U-shape, the opening of the U-shape faces the side away from the bonding area 21. For example, the U-shaped opening faces upward.

For example, the lower pad area may include sector wiring electrically connected to the data line.

For example, as shown in Fig. 5 and Fig. 9A, in the same pixel circuit, the channel region of the data writing transistor T4 is located on the side of the channel region of the driving transistor T3 near the lower pad region. For example, in the same pixel circuit, the channel region of the data writing transistor T4 is located on the side of the channel region of the driving transistor T3 near the lower pad region. For example, in the same pixel circuit, the channel region of the second light-emitting control transistor T5 is located on the side of the channel region of the driving transistor T3 away from the lower pad region. For example, in the same pixel circuit, the channel region of the first reset control transistor T7 is located on the side of the channel region of the driving transistor T3 away from the lower pad region.

For example, the display substrate further includes a camera area for placing cameras. For example, the camera area may be located on the side of the display area away from the bonding area (such as the upper side of the display area), or located in the center of the display area away from the bonding area. For example, the camera area is located on the side of the display area away from the bonding area, and the light-emitting control transistor in the pixel circuit is located on the side of the driving transistor close to the camera area. For example, the camera area is located on the side of the center of the display area away from the bonding area, and the light-emitting control transistor in the pixel circuit between the camera area and the bonding area is located on the side of the driving transistor close to the camera area.

For example, the semiconductor layer forming the channel region of the second reset transistor T1 and the threshold compensation transistor T2 in the pixel circuit may be located on the side of the active semiconductor pattern away from the base substrate, and the semiconductor layer may include an oxide semiconductor material. For example, in the case of the active layer of the second reset transistor T1 and the active layer of the threshold compensation transistor T2 of the pixel circuit are made of oxide semiconductors, because the transistors using oxide semiconductors have the characteristics of good hysteresis, low leakage current, and low mobility, the transistors of oxide semiconductors can be used to replace the low-temperature polysilicon materials in the transistors to form a low-temperature polysilicon-oxide (LTPO) pixel circuit to achieve low leakage and improve the stability of the gate voltage of the transistors.

Of course, the embodiment of the present disclosure is not limited to the active semiconductor pattern of the pixel circuit as that shown in Fig. 9A, the semiconductor layer of the channel regions of the second reset transistor T1 and the threshold compensation transistor T2 may also be located in the same layer as the semiconductor layer of the channel region of other transistors, that is, the active semiconductor pattern may include the channel regions of a second reset transistor T1, a threshold compensation transistor T2, a driving transistor T3, a data writing transistor T4, a second light-emitting control transistor T5, the first light-emitting control transistor T6, and the first reset control transistor T7.

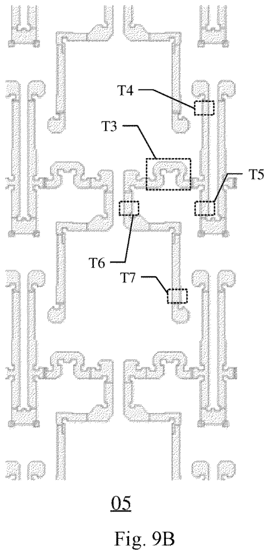

Fig. 9B shows a partial structure diagram of the active semiconductor pattern in the display substrate shown in Fig. 1. For example, as shown in Fig. 9B, an active semiconductor pattern 05 can be formed by patterning a semiconductor material. The active semiconductor pattern 05 can be used to form the active layer of the driving transistor T3, the data writing transistor T4, the second light-emitting control transistor T5, the first light-emitting control transistor T6 and the first reset control transistor T7 to form the channel regions of the transistors. For example, the active semiconductor pattern 05 can be made of amorphous silicon, polysilicon, oxide semiconductor materials, etc. It should be noted that the source region and drain region described above may be regions doped with n-type impurities or p-type impurities.

For example, the active semiconductor pattern 05 is provided with a metal layer on the side away from the base substrate, such as a gate metal layer, the metal layer comprises the scanning signal line, the reset control signal line, the light-emitting control signal line, and the gate electrodes of the driving transistor T3, the data writing transistor T4, the second light-emitting control transistor T5, the first light-emitting control transistor T6 and the first reset control transistor T7. Each dashed rectangular frame in Fig. 9B shows the portions of the active semiconductor pattern 05 overlapping with the conductive layer where the gate electrodes of the various transistors are formed so as to be formed as the channel regions of the respective transistors. For example, the semiconductor layer forming the channel regions of the second reset transistor T1 and the threshold compensation transistor T2 in the pixel circuit may be located on the side of the active semiconductor pattern away from the base substrate, and the semiconductor layer may include an oxide semiconductor material.

For example, as shown in Fig. 1 to Fig. 3 and Fig. 9B, in the same pixel circuit of at least one pixel circuit, the channel region of the driving transistor T3 is located on the side of the channel region of the light-emitting control transistor T6 away from the lower pad region.

For example, as shown in Fig. 1 to Fig. 3 and Fig. 9B, in the same pixel circuit of at least one pixel circuit, the channel region of the second light-emitting control transistor T5 is located on the side of the channel region of the driving transistor T3 close to the lower pad region.

For example, as shown in Fig. 1 to Fig. 3 and Fig. 9B, in the subpixels closest to the lower pad region, the pixel circuit is closer to the lower pad region than the first electrode of the light-emitting element. For example, the active semiconductor pattern 05 includes a portion located between the boundary B01 and the boundary B02.

For example, as shown in Fig. 1 to Fig. 3 and Fig. 9B, the shape of the channel region of the driving transistor T3 includes a U-shape, and the U-shaped opening faces the side of the peripheral region 20 where the bonding area 21 is located. For example, the U-shaped opening faces down.

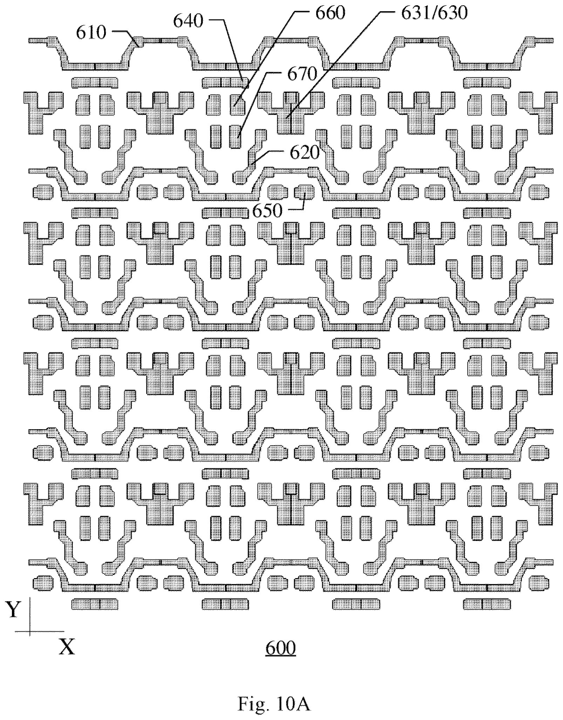

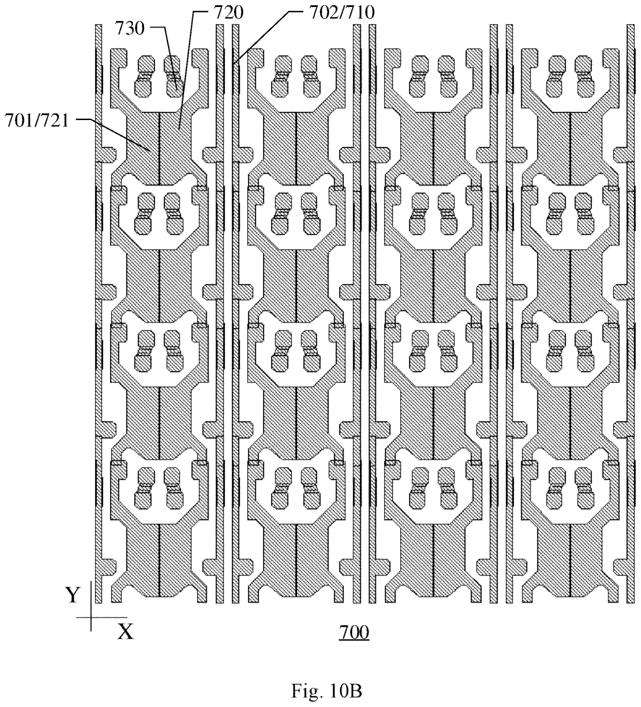

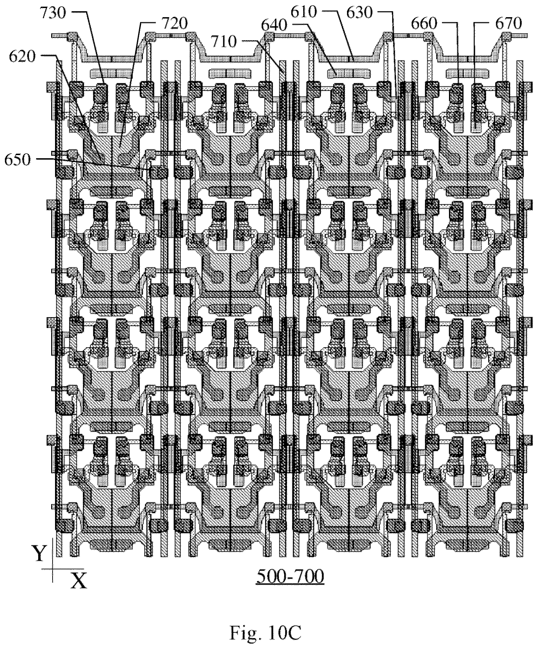

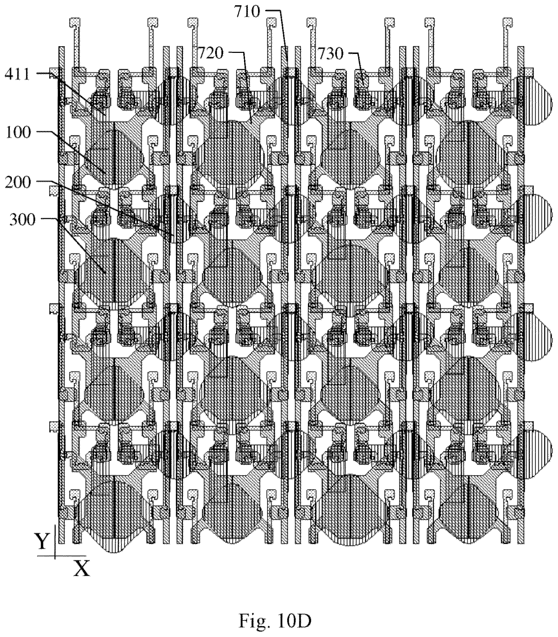

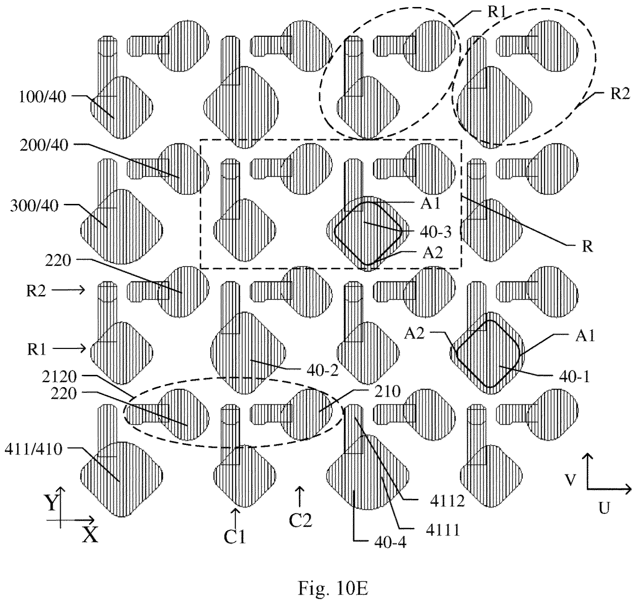

Fig. 10A is a partial structure diagram of the first conductive layer provided according to the embodiment of the present disclosure, Fig. 10B is a partial structure diagram of the second conductive layer provided according to the embodiment of the present disclosure, Fig. 10C is a schematic diagram showing a stack structure of an active semiconductor pattern, a first conductive layer, and the second conductive layer provided according to the embodiment of the present disclosure, Fig. 10D is a schematic diagram showing a stack structure of an active semiconductor pattern, a second conductive layer, and a first electrode of the light-emitting element provided according to the embodiment of the present disclosure, Fig. 10E is a structural diagram of the first electrode of the light-emitting element provided according to the embodiment of the present disclosure. Fig. 10A to Fig. 10E are schematic diagrams illustrating stack structures of only some of the layers in the display substrate, and other layers may include a layer where gate lines are located, a layer of the semiconductor layer where the channel regions of the second reset transistor T1 and the threshold compensation transistor T2 are located.

For example, as shown in Fig. 8, Fig. 9A, Fig. 10A to Fig. 10D, the display substrate includes a first conductive layer 600 (e.g., SD1 layer) located between the first electrode of the light-emitting element and the base substrate, the first conductive layer 600 includes a reset power signal line 610, the reset power signal line 610 is electrically connected with the first electrode of the first reset transistor T7 to provide a reset signal. For example, the above reset power signal line 610 may be a first reset power signal line electrically connected to the first electrode of the first reset transistor T7, the display substrate further comprises a second reset power signal line, a first portion of the second reset power signal line is located between the first conductive layer 600 and the layer where the gate electrode of the first reset transistor T7 is located, and is configured to be electrically connect with the first electrode of the second reset transistor T1 to provide a reset signal.

For example, as shown in Fig. 8, Fig. 9A, Fig. 10A to Fig. 10D, the first conductive layer 600 further comprises a connection structure 620, one end of the connection structure 620 is electrically connected with the gate electrode of the driving transistor T1, the other end of the connection structure 620 is electrically connected to the second electrode of the second reset transistor T1 and the second electrode of the threshold compensation transistor T2.

For example, as shown in Fig. 8, Fig. 9A, Fig. 10A to Fig. 10D, the first conductive layer 600 further comprises a first power signal line 630, the display substrate further comprises a second conductive layer 700 (for example, an SD2 layer) located between the first conductive layer 600 and the first electrode of the light-emitting element, the second conductive layer 700 includes a data line 710 and a second power signal line 720 extending in the Y direction, each first power signal line 630 is electrically connected to two second power signal lines 720 located on either side thereof to form a grid. The grid-like power signal line can be electrically connected to the second power signal lines of the respective pixels, which is conducive to reducing the voltage drop of the second power signal line, thereby improving the uniformity of the display device.

For example, as shown in Fig. 8, Fig. 9A, Fig. 10A to Fig. 10D, the first conductive layer 600 further comprises a second portion 640 electrically connected to the first portion of the second reset power signal line.

For example, as shown in Fig. 8, Fig. 9A, Fig. 10A to Fig. 10D, the first conductive layer 600 further comprises a connection structure 650, the second electrode of the data writing transistor T4 is electrically connected to the data line 710 through the connection structure 650 to receive a data signal.

For example, as shown in Fig. 8, Fig. 9A, Fig. 10A to Fig. 10D, the first conductive layer 600 further comprises a connection structure 660 (i.e., a first connection structure 660), the second conductive layer 700 further comprises a connection structure 730 (i.e., a second connection structure 730), the second electrode of the first light-emitting control transistor T6 is electrically connected to the first electrode 411 of the light-emitting element via a first connection structure 660 and a second connection structure 730.

For example, as shown in Fig. 8, Fig. 9A, Fig. 10A to Fig. 10D, the first conductive layer 600 further comprises a connection structure 670, the first electrode of the first light-emitting control transistor T6 is electrically connected to the first electrode of the threshold compensation transistor T2 via the connection structure 670.

For example, as shown in Fig. 4, Fig. 10B and Fig. 10D, the second power signal line 720 includes a pad block 721, a plurality of second power signal lines 720 comprise a plurality of pad blocks 721 that may overlap with the first electrodes at the light-emitting regions of the light-emitting elements of some subpixels (for example, at least one of the first subpixel 100 and the third subpixel 100 which will be described later), to improve the flatness of the light-emitting functional layer at the light-emitting regions of the subpixels, reduce the probability of color cast and other defects during display, and improve the display effect.

For example, as shown in Fig. 4 and Fig. 10A, the first power signal line 630 includes a pad block 631, a plurality of first power signal line 630 comprises a plurality of pad blocks 631 that may overlap with the first electrode at the light-emitting region of the light-emitting element of another part of the subpixels (for example, the second subpixel 200 which will be described later) to improve the flatness of the light-emitting functional layer at the light-emitting region of the subpixel, reduce the probability of color casts and other defects during display, and improve the display effect.

For example, as shown in Fig. 4 to Fig. 6, in the subpixel 40 closest to the bonding area 21, the end of the active semiconductor pattern 500 of the pixel circuit 420 closest to the bonding area 21 is the first end 501, the end of the first electrode 411 of the light-emitting element 410 closest to the bonding area 21 is the second end 4110, the second end 4110 is closer to the bonding area 21 than the first end 501.

For example, as shown in Fig. 4 to Fig. 6 and Fig. 9A, in the subpixel 40 closest to the bonding area 21, the first end 501 of the active semiconductor pattern 500 of the pixel circuit 420 closest to the bonding area 21 is the second electrode of the data writing transistor T4 to be electrically connected with the data line 710. For example, the second end 4110 of the first electrode 411 of the light-emitting element 410 may be a point where the first electrode 411 is closest to the bonding area.

For example, as shown in Fig. 4 to Fig. 6, the boundary of the display area 10 close to the peripheral area 20 where the bonding area 21 is located is boundary B 10; in the subpixel 40 closest to the bonding area 21, the distance between the first end 501 of the active semiconductor pattern 500 in the pixel circuit 420 and the boundary B10 is greater than the distance between the second end 4110 of the first electrode 411 of the light-emitting element 410 and the boundary B10.

For example, as shown in Fig. 4 to Fig. 6, in the subpixel 40 closest to the bonding area 21, the active semiconductor pattern 500 of the pixel circuit 420 is located within the boundary B10 of the display area 10.

For example, as shown in Fig. 4 to Fig. 6, in the subpixel 40 closest to the bonding area 21, each transistor of the pixel circuit 420 is located in the display area 10. For example, in the subpixel 40 closest to the bonding area 21, the channel region of each transistor of the pixel circuit 420 is farther away from the bonding area 21 than the second end 4110 of the first electrode 411 of the light-emitting element 410.

For example, as shown in Fig. 6, the second signal transmission line 25 is electrically connected with the second power signal line 720 to transmit a power signal, such as a VDD signal, to the second power signal line 720. For example, the second signal transmission line 25 includes a plurality of openings to facilitate the deformation of the organic layer between the second signal transmission line 25 and the base substrate and the release of water vapor, etc. By releasing water vapor from the organic layer, the light-emitting element of the display area can be effectively protected.

For example, the distance between a boundary B20 of the side of the second signal transmission line 25 close to the display area 10 and the boundary B10 of the display area 10 shown in Fig. 6 is smaller than the distance between the boundary B01 and the boundary B02 shown in Fig. 3 by 30 to 50 microns. For example, the distance between the boundary B20 of the side of the second signal transmission line 25 close to the display area 10 and the boundary B10 of the display area 10 shown in Fig. 6 is smaller than the distance between boundary B01 and the boundary B02 shown in Fig. 3 by 35 to 45 microns. The distance between the boundary B20 on the side of the second signal transmission line 25 close to the display area 10 and the boundary B10 of the display area shown in Fig. 6 is smaller than the distance between the boundary B01 and the boundary B02 shown in Fig. 3 by 37 to 42 microns. The distance between the boundary B20 on the side of the second signal transmission line 25 close to the display area 10 and the boundary B10 of the display area shown in Fig. 6 is smaller than the distance between the boundary B01 and the boundary B02 shown in Fig. 3 by 39 to 40 microns.

In the display substrate provided by the embodiment of the present disclosure, by disposing the light-emitting control transistor of the pixel circuit on the side of the driving transistor away from the bonding area, the first electrode in the pixel circuit closest to the bonding area may be closer to the bonding area than the transistors of the pixel circuit, which is conducive to reducing the distance between the boundary of the display area close to the bonding area and the edge of the second signal transmission line in the pad area where the bonding area is located, so that the pad area does not need to kept at a large size, and it is beneficial to reduce the size of the lower border of the display device.

For example, as shown in Fig. 4, Fig. 5 and Fig. 9A, in the same subpixel of at least one subpixel 40, the channel region of the light-emitting control transistor T6 is located on a side of the center of the light-emitting region 401 of the light-emitting element 410 away from the bonding area 21. For example, in at least one subpixel 40, the light-emitting control transistor T6 is located on the side of the light-emitting region 401 of the light-emitting element 410 away from the bonding area 21. For example, in the subpixels of the same color in at least one row of subpixels 40, the channel region of the light-emitting control transistor T6 is located on a side of the center of the light-emitting element 410 of the light-emitting region 401 away from the bonding area 21. For example, in the subpixels of the same color in at least two rows of subpixel 40, the channel region of the light-emitting control transistor T6 is located on a side of the center of the light-emitting region 401 of the light-emitting element 410 away from the bonding area 21. For example, in each subpixel 40 in the at least one row of subpixels 40, the channel region of the light-emitting control transistor T6 is located on a side of the center of the light-emitting region 401 of the light-emitting element 410 away from the bonding area 21. For example, in each subpixel 40, the channel region of the light-emitting control transistor T6 is located on the side of the light-emitting region 401 of the light-emitting element 410 away from the bonding area 21.

The center of the light-emitting region described above is, for example, the geometric center of the light-emitting region of the subpixel, or the intersection point of the perpendicular bisector lines of each side of the light-emitting region of the subpixel, or the point where the vertical distance to each side in the light-emitting region of the subpixel is roughly equal. Of course, the center of the above-mentioned light-emitting region can allow for a certain error. For example, the center of the light-emitting region can be any point within a circle centered on the geometric center of the light-emitting region and having a radius of 3 µm.

For example, a plurality of subpixels 40 includes different color subpixels configured to emit different colors of light. In a subpixel of emitting one color, the light-emitting control transistor T6 is located on the side of the light-emitting region 401 of the light-emitting element 410 away from the bonding area 21. For example, in subpixels of emitting two different colors, the light-emitting control transistor T6 is located on the side of the light-emitting region 401 of the light-emitting element 410 away from the bonding area 21.

For example, as shown in Fig. 4 and Fig. 10E, a plurality of subpixels 40 includes a plurality of first subpixels 100, a plurality of second subpixels 200, and a plurality of third subpixels 300. For example, one of the first subpixel 100 and the third subpixel 300 is a red subpixel emitting red light, the other one of the first subpixel 100 and the third subpixel 300 is a blue subpixel emitting blue light, and the second subpixel 200 is a green subpixel emitting green light. For example, the first subpixel 100 is a red subpixel, the third subpixel 300 is a blue subpixel, and the area of the light-emitting region of the blue subpixel is greater than the area of the light-emitting region of the red subpixel. For example, the area of the light-emitting region of a blue subpixel is greater than the area of the light-emitting region of the green subpixel. Of course, the present embodiment is not limited to this, the names of the first subpixel, the second subpixel and the third subpixel may be exchangeable, such as the first subpixel may be a green subpixel, the second subpixel may be a blue subpixel, and the third subpixel may be a red subpixel; alternatively, the first subpixel can be a blue subpixel, the second subpixel can be a red subpixel, the third subpixel can be a green subpixel, and so on.

For example, as shown in Fig. 4 and Fig. 10E, a plurality of first subpixels 100 and a plurality of third subpixels 300 are alternately disposed in the first direction (X direction as shown) and the second direction (Y direction as shown) to form a plurality of first pixel rows R1 and a plurality of first pixel columns C1, a plurality of second subpixels 200 arranged in array along the first and second directions to form a plurality of second pixel rows R2 and a plurality of second pixel columns C2. A plurality of first pixel rows R1 and a plurality of second pixel rows R2 are alternately arranged in the second direction and staggered from each other in the first direction, and a plurality of first pixel columns C1 and a plurality of second pixel columns C2 are alternately arranged in the first direction and staggered from each other in the second direction, and the first direction and the second direction are intersected with each other. For example, the first direction can be perpendicular to the second direction. For example, the first direction and the second direction are exchangeable.

For example, the centers of the light-emitting regions of the adjacent first subpixel 100 and third subpixel 300 in the first pixel row R1, and the centers of the light-emitting regions of the first subpixel 100 and the third subpixel 300 respectively adjacent to the adjacent first subpixel 100 and third subpixel 300 in the first pixel row R1 along the column direction are four vertices of a virtual quadrilateral, and the center of the light-emitting region of a second subpixel 200 is provided within the virtual quadrilateral.

For example, as shown in Fig. 4 and Fig. 10E, a second pixel row R2 comprises a plurality of second subpixel pairs 2120 arranged in the first direction, two second subpixels 200 in one second subpixel pair 2120 are a first pixel block 210 and a second pixel block 220, respectively, and the first pixel blocks 210 and the second pixel blocks 220 are alternately arranged in the first direction. For example, the first pixel blocks 210 and the second pixel blocks 220 of in one second pixel column C2 are alternately arranged in the second direction.

For example, as shown in Fig. 4 and Fig. 10E, at least two second pixel rows R2 include a plurality of second subpixel pairs 2120 arranged in the first direction, two second subpixels 200 in at least two second subpixel pairs 2120 are the first pixel block 210 and the second pixel block 220, respectively, and the first pixel blocks 210 and the second pixel blocks 220 are alternately arranged in the first direction. For example, the first pixel block 210 and the second pixel block 220 in at least two second pixel columns C2 are alternately arranged in the second direction.

For example, as shown in Fig. 4 and Fig. 10E, each second pixel row R2 comprises a plurality of second subpixel pairs 2120 arranged in the first direction, two second subpixels 200 in each second subpixel pair 2120 are the first pixel block 210 and the second pixel block 220, respectively, and the first pixel blocks 210 and the second pixel blocks 220 are alternately arranged in the first direction. For example, the first pixel block 210 and the second pixel block 220 in each second pixel column C2 are alternately arranged in the second direction.

For example, as shown in Fig. 4 and Fig. 10E, a plurality of subpixels 40 includes a plurality of minimum repeating units R, a minimum repeating unit R comprises one first subpixel 100, one first pixel block 210, one second pixel block 220, and one third subpixel 300. For example, at least two minimum repeating units R each include one first subpixel 100, one first pixel block 210, one second pixel block 220, and one third subpixel 300. For example, each minimum repeating unit R comprises one first subpixel 100, one first pixel block 210, one second pixel block 220, and one third subpixel 300. For example, each minimum repeating unit R includes two rows and four columns of subpixels 40.

For example, as shown in Fig. 4 and Fig. 10E, in a minimum repeating unit R, the first pixel block 210 and the first subpixel 100 constitute the first pixel unit R1, the second pixel block 220 and the third subpixel 300 constitute the second pixel unit R2. For example, in each of at least two minimum repeating units R, the first pixel block 210 and the first subpixel 100 constitute the first pixel unit R1, and the second pixel block 220 and the third subpixel 300 constitute the second pixel unit R2. For example, in each minimum repeating unit R, the first pixel block 210 and the first subpixel 100 constitute the first pixel unit R1, and the second pixel block 220 and the third subpixel 300 constitute the second pixel unit R2.

The above first pixel unit and second pixel unit are not strictly pixels, that is, a pixel defined by all of a first subpixel, a second subpixel, and a third subpixel. The minimum repeating unit here refers to the pixel arrangement structure may include a plurality of repeating arrangements of the smallest repeating unit.

For example, the first subpixel 100 and the third subpixel 300 are shared subpixels, and by the virtual algorithm, four subpixels can be displayed in two virtual pixel units. For example, in the same row of repeating units, the first subpixel 100 in the second repeating unit, the third subpixel 300 in the first repeating unit, and the second subpixel 200 in the first repeating unit close to the second repeating unit form a virtual pixel unit, while the first subpixel 100 in the second repeating unit also forms a virtual pixel unit with the third subpixel 300 in the repeating unit and the second subpixel 200 in the repeating unit close to the first repeating unit. Further, the third subpixel 300 in the second repeating unit also forms a virtual pixel unit with another second subpixel 200 in the repeating unit and the first subpixel 100 in the third repeating unit, thereby effectively improving the resolution of the display substrate.

For example, as shown in Fig. 4, Fig. 6 and Fig. 10E, in the first pixel unit R1, the first pixel block 210 is located on the side of the first subpixel 100 away from the bonding area 21. In the second pixel unit R2, the second pixel block 220 is located on the side of the third subpixel 300 away from the bonding area 21.

For example, the direction pointed by the arrow in the Y direction is upward, the direction pointed by the arrow in the X direction is right, the first pixel block 210 in the first pixel unit R1 is located at the upper right of the first subpixel 100, and the second pixel block 220 in the second pixel unit R2 is located at the upper right of the third subpixel 300.

In the first pixel unit and the second pixel unit of the display substrate provided in the embodiment of the present disclosure, the pixel space and design are optimized by changing the first subpixel and the third subpixel to borrow the second subpixel at different positions, thereby improving the flatness of the first electrode of the light-emitting element and optimizing the pixel space structure, thereby narrowing the lower border.

For example, as shown in Fig. 4 and Fig. 5, in a same subpixel of at least one of the first subpixel 100 and the third subpixel 300, the channel region of the light-emitting control transistor T6 is located at the side of the center of the light-emitting element 410 away from the bonding area 21. For example, in the same subpixel of the first subpixel 100 and the third subpixel 300, the channel region of the light-emitting control transistor T6 is located at the side of the center of the light-emitting region of the light-emitting element 410 away from the bonding area 21.

For example, as shown in Fig. 10E, the first subpixel 100 forms a first pixel unit with the second subpixel 200 located at the upper right of the first subpixel 100 or the second subpixel 200 located at the lower right of the first subpixel 100. Similarly, the third subpixel 300 forms the second pixel unit with a second subpixel 200 located at the upper right of the third subpixel 300 or the second subpixel 100 located at the lower right of the third subpixel 300. In the present embodiment, in the first subpixel 100, the light-emitting control transistor T6 is located above the light-emitting region, by forming a first pixel unit with the first subpixel 100 and the second subpixel 200 located at the upper right of the first subpixel 100, the pixel circuit design is facilitated, the probability of changing the shape of the pad for planarization in the second conductive layer to affect the flatness of the pixel is reduced, which is conducive to preventing the generation of color cast. In addition, it can also reduce the impact on the capacitance of the node corresponding to the first electrode of the light-emitting element, such as preventing the impact of the image quality of the low gray level. If the capacitance here is larger, the capacitor of the first electrode of the light-emitting element needs to be fully charged at the low gray level, resulting in a decrease in the voltage of charging the node at the low gray level, so that the pixel lighting time will be longer (response time), which in turn affects the image quality. Similarly, in the third subpixel 300, the light-emitting control transistor T6 is located above the light-emitting region, and the third subpixel 300 constitutes a second pixel unit with the second subpixel 200 located at the upper right of the third subpixel 300, which can facilitate the pixel circuit design.

For example, as shown in Fig. 4, Fig. 9A, Fig. 10A to Fig. 10E, in the first pixel unit R1, the pixel circuit of the first pixel block 210 and the pixel circuit of the first subpixel 100 are arranged in the first direction. In the second pixel unit R2, the pixel circuit of the second pixel block 220 and the pixel circuit of the third subpixel 300 are arranged in the first direction. For example, the pixel circuits of two subpixels located in the same pixel unit are arranged in the first direction to facilitate pixel borrowing.

For example, as shown in Fig. 4, Fig. 9A, Fig. 10A to Fig. 10E, in the first pixel unit R1, the active semiconductor pattern 500 of the first pixel block 210 and the active semiconductor pattern 500 of the first subpixel 100 are symmetrically distributed relative to a straight line located between them and extending in a second direction. In the second pixel unit R2, the active semiconductor pattern 500 of the second pixel block 220 and the active semiconductor pattern 500 of the third subpixel 300 are symmetrically distributed relative to the straight line located between them and extending in the second direction, which is conducive to saving the distribution space of the active semiconductor pattern.

For example, as shown in Fig. 4, Fig. 9A, Fig. 10A to Fig. 10E, the active semiconductor pattern 500 of the first pixel block 210 in the first pixel unit R1 and the active semiconductor pattern 500 of the third subpixel 300 adjacent to the first pixel block 210 and in the second pixel unit R2 are an integrated structure, which can save the distribution space of the active semiconductor pattern, while the two data lines can be disposed to overlap the light-emitting region of the second subpixel to help improve the flatness of the light-emitting functional layer in the light-emitting region of the second subpixel. For example, the active semiconductor pattern 500 of the second pixel block 220 in the second pixel unit R2 and the active semiconductor pattern 500 of the first subpixel 100 located in the first pixel unit R1 and adjacent to the second pixel block 220 are an integrated structure, which can save the distribution space of the active semiconductor pattern, while the two data lines may be disposed to overlap with the light-emitting region of the second subpixel to facilitate the flatness of the light-emitting functional layer in the light-emitting region of the second subpixel.

For example, as shown in Fig. 4, Fig. 9A, Fig. 10A to Fig. 10E, the first subpixel 100 is provided with two data lines 710 on each side in the X direction. For example, two data lines 710 are provided between the first subpixel 100 and the third subpixel 300 adjacently arranged in the X direction.

For example, as shown in Fig. 4 and Fig. 10E, the first electrode 411 of the light-emitting element 410 includes a main electrode 4111 and a connecting electrode 4112 electrically connected to each other, the main electrode 4111 overlaps with the light-emitting region 401 of the light-emitting element 410, the connecting electrode 4112 does not overlap with the light-emitting region 401, and the connecting electrode 4112 is electrically connected with the light-emitting control transistor T6. For example, the main electrode 4111 and the connecting electrode 4112 may be an integrated structure.

For example, as shown in Fig. 4, Fig. 10A to Fig. 10E, the shape of the main electrode 4111 is approximately the same as the shape of the light-emitting region 401, such as a quadrilateral. For example, the orthographic projection of the light-emitting region 401 on the base substrate 11 is located within the orthographic projection of the main electrode 4111 on the base substrate 11.

For example, as shown in Fig. 4, Fig. 10A to Fig. 10E, in the first subpixel 100 and the third subpixel 300, the orthographic projection of at least part of the main electrode 4111 on the base substrate 11 and the orthographic projection of the pad block 721 on the base substrate 11 overlap with each other. For example, in the first subpixel 100 and the third subpixel 300, the orthographic projection of the center of the main electrode 4111 on the base substrate 11 is located within the orthographic projection of the pad block 721 on the base substrate 11. For example, in the first subpixel 100 and the third subpixel 300, the orthographic projection of the center of the light-emitting region 401 on the base substrate 11 is located within the orthographic projection of the pad block 721 on the base substrate 11. For example, in the first subpixel 100 and the third subpixel 300, the orthographic projection of the light-emitting region 401 on the base substrate 11 is located within the orthographic projection of the pad block 721 on the base substrate 11.

For example, as shown in Fig. 4, Fig. 10A to Fig. 10E, in the first subpixel 100 and the third subpixel 300, the orthographic projection of the main electrode 4111 on the base substrate 11 overlaps with the orthographic projection of the reset power signal line 610, the connection structure 620, and the second part 640 of the second reset power signal line on the base substrate 11. In the first subpixel 100 and the third subpixel 300, the orthographic projection of each main electrode 4111 on the base substrate 11 and the orthographic projection of two connection structures 620 on the base substrate 11 overlap with each other.

For example, as shown in Fig. 4, Fig. 10A to Fig. 10E, the two connection structures 620 overlapping with the main electrode 4111 in the first subpixel 100 and the third subpixel 300 are roughly symmetrically distributed relative to the centerline of the main electrode 4111 extending in the Y direction to improve the flatness of the subpixels. For example, the reset power signal line 610 overlapping with the main electrode 4111 in the first subpixel 100 and the third subpixel 300 substantially covers the center line of the main electrode 4111 extending in the X direction to improve the flatness of the subpixel.

For example, as shown in Fig. 4, Fig. 10A to Fig. 10E, the orthographic projection of the main electrode 4111 in the second subpixel 200 on the base substrate 11 overlaps with the orthographic projection of the pad block 631, the data line 710, and the second power signal line 720 on the base substrate 11.

For example, as shown in Fig. 4, Fig. 10A to Fig. 10E, the orthographic projection of the main electrode 4111 in the second subpixel 200 on the base substrate 11 overlaps with the two data lines 710, and the overlapping portions of the two data lines 710 and the main electrode 4111 is basically symmetrically distributed relative to the center line of the main electrode 4111 extending in the Y direction to improve the flatness of the subpixels.

For example, as shown in Fig. 4, Fig. 10A to Fig. 10E, the second conductive layer 700 further comprises a first overlap portion 701 overlapping with the light-emitting region 401 of at least one of the first subpixel 100 and the third subpixel 300 (e.g., as a part of the pad block 721), the ratio of the area of the first overlap portion 701 to the area of the light-emitting region 401 is 0.6-1. For example, the ratio of the area of the first overlap portion 701 to the area of the light-emitting region 401 is 0.7~0.9. For example, the ratio of the area of the first overlap portion 701 to the area of the light-emitting region 401 is 0.75~0.85.

For example, as shown in Fig. 4, Fig. 10A to Fig. 10E, the first overlap portion 701 is basically symmetric with respect to the straight line extending in the second direction.

For example, as shown in Fig. 4, Fig. 10A to Fig. 10E, the second conductive layer 700 further comprises a second intersection 702 overlapping with the light-emitting region 401 of the second subpixel 200 (e.g., as a part of the data line 710), the second overlap portion 702 is substantially symmetric with respect to a straight line extending in the second direction.

For example, in each subpixel 40, the connecting electrode 4112 is electrically connected with the light-emitting control transistor T6 via a first connection structure 660 and a second connection structure 730. For example, the second connection structure 730 includes two ends, one end of the second connection structure 730 overlaps with the connecting electrode 4112 to be electrically connected with the connecting electrode 4112 through a via hole located in an insulating layer, and the other end of the second connection structure 730 overlaps with the first connection structure 660 to be electrically connected with the first connection structure 660 through a via hole located in another insulation layer.

For example, as shown in Fig. 4, Fig. 10A to Fig. 10E, in a same subpixel of at least one of the first subpixel 100 and the third subpixel 300, the channel region of the light-emitting control transistor T6 is located on the side of the center of the main electrode 4111 away from the bonding area 21. For example, in a same subpixel of the first subpixel 100 and the third subpixel 300, the channel region of the light-emitting control transistor T6 is located on the side of the center of the main electrode 4111 away from the bonding area 21. In the same subpixel of at least one of the first subpixel 100 and the third subpixel 300, the connecting electrode 4112 is located on the side of the main electrode 4111 away from the bonding area 21.

For example, as shown in Fig. 4 to Fig. 6 and Fig. 10A to Fig. 10E, the row of subpixels 40 closest to the bonding area 21 is the first pixel row R1. For example, a row of subpixels 40 closest to the bonding area 21 includes first subpixels 100 and third subpixels 300 alternately arranged. For example, the row of subpixels 40 closest to the bonding area 21 includes red subpixels 100 and blue subpixels 300 alternately arranged.

For example, as shown in Fig. 4 to Fig. 6 and Fig. 10A to Fig. 10E, for the same second subpixel 200, the distances from the channel region of the light-emitting control transistor T6 and the center of the light-emitting region 401 of the light-emitting element 410 to the bonding area 210 are respectively a first distance and a second distance, the first distance is greater than the second distance. For example, in the channel region of the light-emitting control transistor T6 and the light-emitting region 401 of the light-emitting element 410 of the same second subpixel 200, the channel region is farther away from the bonding area 21 relative to the light-emitting element 410 of the light-emitting region 401.

For example, as shown in Fig. 4 to Fig. 6 and Fig. 10A to Fig. 10E, in at least one of the first subpixel 100 and the third subpixel 300, the corners of the light-emitting region 401 of the light-emitting element 410 includes a first corner A1 and a second corner A2 opposite to each other. The distance from the intersection of the two extension lines of the two lines forming the first corner A1 to the center of the light-emitting region 401 is greater than the distance from the intersection of the two lines constituting the second corner A2 or their extension lines to the center of the light-emitting region 401. For example, in the first subpixel 100, the corners of the light-emitting region 401 of the light-emitting element 410 comprises the first corner A1 and the second corner A2 opposite to each other.

For example, as shown in Fig. 4 to Fig. 6 and Fig. 10A to Fig. 10E, at least one of the first subpixel 100 and the third subpixel 300 include a first type subpixel 40-1 and a second type subpixel 40-2, in different types of subpixels, the directions from the vertex of the first corner A1 to the vertex of the second corner A2 are different. In the first type subpixel 40-1 and the second type subpixel 40-2, the directions from the vertex of the first corner A1 to the vertex of the second corner A2 are a first orientation and a second orientation, respectively, and the first orientation and the second orientation are opposite to each other. For example, the first subpixel 100 includes a first type subpixel 40-1 and a second type subpixel 40-2.

For example, the first orientation can be a direction pointed by the arrow in the U direction shown in the figure, the second orientation can be a direction opposite to the direction pointed by the arrow in the U direction, and the first orientation and the second orientation can be exchangeable. For example, the first orientation can also be a direction pointed by the arrow in the V direction shown in the figure, and the second orientation can also be a direction opposite to the direction pointed by the arrow in the V direction, and the first orientation and the second orientation can be exchanged.

For example, as shown in Fig. 4 to Fig. 6 and Fig. 10A to Fig. 10E, the first corner A1 of the light-emitting region of the third subpixel 300 may be a rounded corner, and the distance between the first corner A1 of the light-emitting region of the third subpixel 300 and the corner of the light-emitting region of the first subpixel 100 opposing to the first corner A1 is a first corner spacing, the distance between the second corner A2 of the light-emitting region of the third subpixel 300 and the corner of the light-emitting region of the first subpixel 100 opposing to the second corner A2 is a second corner spacing, and the first corner spacing is greater than the second corner spacing.

The above rounded corner can refer to the corner formed by a curve, which can be an arc or an irregular curve, such as a curve intercepted in an ellipse, wavy lines, etc. The embodiment of the present disclosure illustrates that the curve has a shape protruding outward relative to the center of the subpixel, but it is not limited to this, it may also have a shape recessing towards the center of the subpixel. For example, when the curve is an arc, the range of the central angle of the arc can be 10°~150°. For example, the central angle of the arc can range from 60°~120°. For example, the central angle of the arc can be 90°. For example, the curve length of the rounded corner included in the first corner 111 may be 10-60 microns.

For example, as shown in Fig. 4 to Fig. 6 and Fig. 10A to Fig. 10E, at least one of the first subpixel 100 and the third subpixel 300 further comprises a third type subpixel 40-3 and a fourth type subpixel 40-4. In the third type subpixel 40-3 and the fourth type subpixel 40-4, the directions from the vertex of the first corner A1 to the vertex of the second corner A2 are a third orientation and a fourth orientation, respectively, the third orientation and the fourth orientation are opposite to each other, and the third orientation intersects with the first orientation. For example, the first subpixel 100 further comprises a third type subpixel 40-3 and a fourth type subpixel 40-4.

For example, the third orientation can be a direction pointed by the arrow in the V direction, the fourth orientation can be a direction opposite to the direction pointed by the arrow in the V direction, and the third orientation and the fourth orientation can be exchangeable. For example, the third orientation can be the direction pointed by the arrow in the U direction, the fourth orientation can be a direction opposite to the direction pointed by the arrow in the U direction, and the third orientation and the fourth orientation can be exchangeable.

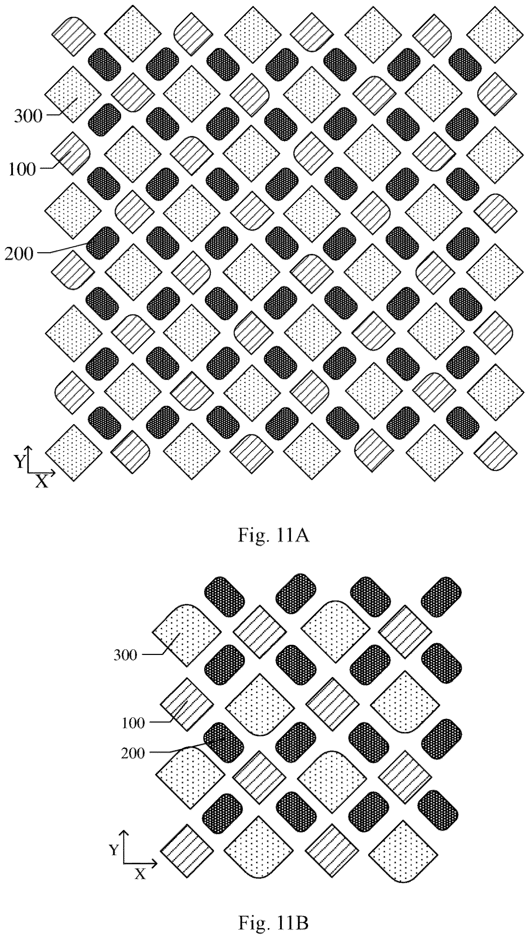

Fig. 11A to Fig. 11E are schematic diagrams of pixel arrangement according to different examples in the present embodiment.

For example, the pixel arrangement shown in Fig. 11A differs from the pixel arrangement shown in Fig. 10E in that the first subpixel 100 may include at least a first type subpixel shown in Fig. 10E, but it is not limited to this. The first subpixel 100 may further include at least one of the second type subpixel, the third type subpixel and the fourth type subpixel shown in Fig. 10E. The present embodiments of the disclosure are not limited to that only the first subpixel or the third subpixel includes at least one of the first type subpixel, the second type subpixel, the third type subpixel and the fourth type subpixel, any two different color subpixels or three different color subpixels in the first subpixel, the second subpixel and the third subpixel, may all include at least one of the first type subpixel, the second type subpixel, the third type subpixel and the fourth type subpixel.

For example, the pixel arrangement shown in Fig. 11B differs from the pixel arrangement shown in Fig. 10E in that the third subpixel 300 only includes two types of subpixels, but it is not limited to this. The third subpixel 300 may also include only one type subpixel or three types of subpixels. For example, when the third subpixel 300 includes only one type subpixel, the type of subpixel may be any type of subpixel shown in Fig. 10E. When the third subpixel 300 includes two types of subpixels, the two types of subpixels may be the first type subpixel and the second type subpixel, or the third type subpixel and the fourth type subpixel as shown in Fig. 10E, but it is not limited to this. The two types of subpixels may also be the first type subpixel and the third type subpixel, or the second type subpixel and the fourth type subpixel, or the first type subpixel and the fourth type subpixel, or the second type subpixel and the third type subpixel, and the present embodiment is not limited thereto.

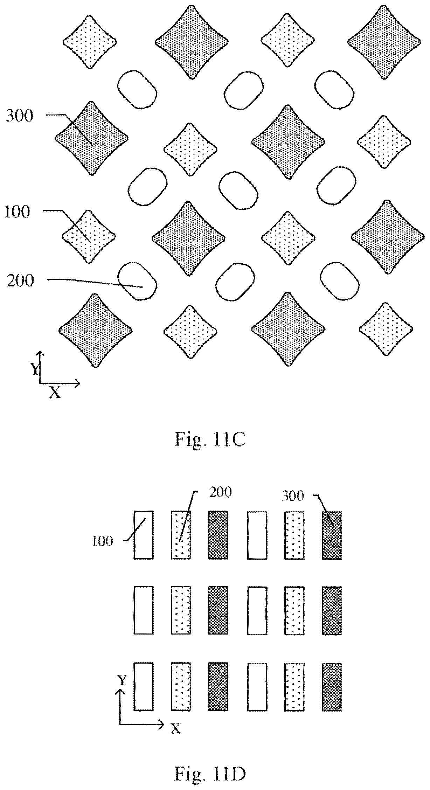

For example, the pixel arrangement shown in Fig. 11C differs from the pixel arrangement shown in Fig. 10E in that each subpixel does not include the four types of subpixels shown in Fig. 10E. For example, as shown in Fig. 11C, the edges of the first subpixel 100 and the third subpixel 300 are curved towards the center of the light-emitting region.

The shape of the light-emitting region of each subpixel may not be limited to the shape shown in the figures, but may also be selected from oval, circle, square, stripe, diamond, trapezoidal or other shapes.

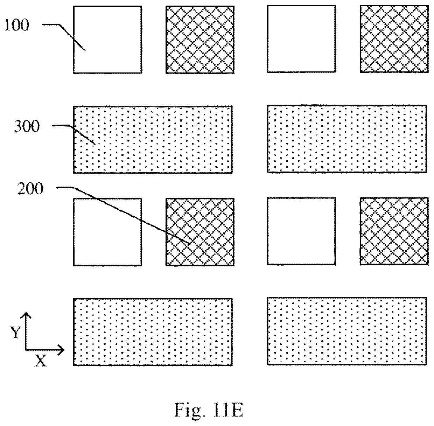

For example, the arrangement of subpixels shown in Fig. 11D and Fig. 11E is different from the arrangement of subpixels shown in Fig. 10E. For example, the pixel arrangement of the first subpixel 100, the second subpixel 200 and the third subpixel 300 can be a real pixel arrangement, a triangular arrangement, or a mosaic pixel arrangement.

For example, as shown in Fig. 11D, the first subpixel 100, the second subpixel 200 and the third subpixel 300 may be arranged sequentially and repeatedly in the X direction or Y direction. For example, as shown in Fig. 11E, the orthographic projections of the light-emitting regions of the first subpixel 100 and the second subpixel 200 on a straight line extending in the X direction overlap with each other.

The present embodiment does not limit the shape of the light-emitting regions of the first subpixel, the second subpixel and the third subpixel in the display substrate having the pixel circuits shown in Fig. 4 to Fig. 10C, and the arrangement of the subpixels.

Another embodiment of the present disclosure provides a display device, including any of the above display substrates. In the display device provided by the embodiment of the present disclosure, by designing a pixel circuit located in the display area, it is conducive to narrowing the lower border of the display device, while making full use of the pixel space.

For example, the display device provided by the embodiment of the present disclosure may be an organic light-emitting diode display device.

For example, the display device may further include a cover plate located on the display side of the display substrate.

For example, the display device may be a mobile phone, tablet computer, laptop, navigator and other products or components with display functions, which have a camera under the screen, and the embodiment of the present disclosure is not limited thereto.

The following statements should be noted:
(1) The accompanying drawings related to the embodiment(s) of the present disclosure involve only the structure(s) in connection with the embodiment(s) of the present disclosure, and other structure(s) can be referred to common design(s).
(2) In case of no conflict, features in one embodiment or in different embodiments of the present disclosure can be combined.

The foregoing is merely exemplary embodiments of the disclosure, but is not used to limit the protection scope of the disclosure. The protection scope of the disclosure shall be defined by the attached claims.

## Claims

1. A display substrate, comprising a display area and a peripheral area located on at least a side of the display area, the display substrate comprising:
a base substrate;
a plurality of subpixels located on the base substrate, at least part of the subpixels located in the display area comprises a light-emitting element and a pixel circuit, the light-emitting element comprising a light-emitting functional layer and a first electrode and a second electrode on both sides of the light-emitting functional layer in a direction perpendicular to the base substrate, the first electrode being located between the light-emitting functional layer and the base substrate; the pixel circuit comprising a driving transistor and a light-emitting control transistor, and the first electrode of the light-emitting element being electrically connected to the light-emitting control transistor; and
a bonding area located in the peripheral area and on a first side of the display area,
wherein the pixel circuit comprises an active semiconductor pattern, the active semiconductor pattern comprises a channel region and a source/drain region of each transistor;
in a same pixel circuit, the channel region of the light-emitting control transistor is located on a side of the channel region of the driving transistor away from the bonding area.

2. The display substrate according to claim 1, wherein, in a subpixel closest to the bonding area, an end of the active semiconductor pattern of the pixel circuit closest to the bonding area is a first end, an end of the first electrode of the light-emitting element closest to the bonding area is a second end, and the second end is closer to the bonding area than the first end.

3. The display substrate according to claim 1 or 2, wherein, in a same subpixel of at least one subpixel, the channel region of the light-emitting control transistor is located on a side of a center of a light-emitting region of the light-emitting element away from the bonding area.

4. The display substrate according to any one of claims 1-3, wherein the plurality of subpixels comprises a plurality of first subpixels, a plurality of second subpixels, and a plurality of third subpixels, the plurality of first subpixels and the plurality of third subpixels are alternately provided in a first direction and a second direction to form a plurality of first pixel rows and a plurality of first pixel columns, the plurality of second subpixels are arranged in array along the first direction and the second direction to form a plurality of second pixel rows and a plurality of second pixel columns, the plurality of first pixel rows and the plurality of second pixel rows are alternately arranged along the second direction and staggered from each other in the first direction, the plurality of first pixel columns and the plurality of second pixel columns are alternately arranged along the first direction and staggered from each other in the second direction, and the first direction and the second direction intersect with each other;
a second pixel row comprising a plurality of second subpixel pairs arranged in the first direction, two second subpixels in each second subpixel pair are a first pixel block and a second pixel block, and the first pixel block and the second pixel block are alternately arranged along the first direction;
the first pixel block and the second pixel block in a second pixel column are alternately arranged in the second direction;
the plurality of subpixels comprises a plurality of minimum repeating units, each minimum repeating unit comprising one first subpixel, one first pixel block, one second pixel block and one third subpixel, in which the first pixel block and the first subpixel constitute a first pixel unit, the second pixel block and the third subpixel constitute a second pixel unit;
in the first pixel unit, the first pixel block is located on a side of the first subpixel away from the bonding area, and in the second pixel unit, the second pixel block is located on a side of the third subpixel away from the bonding area.

5. The display substrate according to claim 4, wherein, in a same subpixel of at least one of the first subpixel and the third subpixel, the channel region of the light-emitting control transistor is located on a side of a center of a light-emitting region of the light-emitting element away from the bonding area.

6. The display substrate according to claim 4 or 5, wherein the first electrode of the light-emitting element comprises a main electrode and a connecting electrode electrically connected to each other, the main electrode overlaps with the light-emitting region of the light-emitting element, the connecting electrode does not overlap with the light-emitting region, and the connecting electrode is electrically connected to the light-emitting control transistor;
in the same subpixel of at least one of the first subpixel and the third subpixel, the channel region of the light-emitting control transistor is located on a side of a center of the main electrode away from the bonding area.

7. The display substrate according to any one of claims 4-6, wherein, for the channel region of the light-emitting control transistor and the light-emitting region of the light-emitting element of the same second subpixel, the channel region is farther away from the bonding area than the light-emitting region of the light-emitting element.

8. The display substrate according to any one of claims 4-7, wherein a shape of the channel region of the driving transistor comprises a U-shape, and the U-shape opens towards a side away from the bonding area.

9. The display substrate according to any one of claims 4-8, wherein a row of subpixels closest to the bonding area is the first pixel row.

10. The display substrate according to any one of claims 4-9, wherein, in the first pixel unit, the pixel circuit of the first pixel block and the pixel circuit of the first subpixel are arranged in the first direction; in the second pixel unit, the pixel circuit of the second pixel block and the pixel circuit of the third subpixel are arranged in the first direction.

11. The display substrate according to any one of claims 4-10, wherein, in the first pixel unit, the active semiconductor pattern of the first pixel block and the active semiconductor pattern of the first subpixel are symmetrically distributed with respect to a straight line located between the two active semiconductor patterns and extending in the second direction; in the second pixel unit, the active semiconductor pattern of the second pixel block and the active semiconductor pattern of the third subpixel are symmetrically distributed with respect to a straight line located between the two active semiconductor patterns and extending in the second direction.

12. The display substrate according to any one of claims 4-11, further comprising:
a first conductive layer located between the first electrode of the light-emitting element and the base substrate;
a second conductive layer located between the first conductive layer and the first electrode of the light-emitting element,
wherein the first conductive layer comprises a first connection structure and a first power signal line, the second conductive layer comprises a data line, a second connection structure and a second power signal line, and the second power signal line is electrically connected to the first power signal line;
the first electrode of the light-emitting control transistor is electrically connected to the driving transistor, and the second electrode of the light-emitting control transistor is electrically connected to the first electrode of the light-emitting element through the first connection structure and the second connection structure.

13. The display substrate according to claim 12, wherein the second conductive layer further comprises a first overlap portion overlapping with a light-emitting region of at least one of the first subpixel and the third subpixel, a ratio of an area of the first overlap portion to an area of the light-emitting region is 0.6-1, and the first overlap portion is substantially symmetrically distributed relative to a straight line extending along the second direction.

14. The display substrate according to claim 12 or 13, wherein the second conductive layer further comprises a second overlap portion overlapping with a light-emitting region of the second subpixel, and the second overlap portion is substantially symmetrically distributed relative to a straight line extending in the second direction.

15. The display substrate according to any one of claims 4-14, wherein, in at least one of the first subpixel and the third subpixel, corners of a light-emitting region of the light-emitting element comprises a first corner and a second corner opposite to each other, and a distance from an intersection of extension lines of two sides constituting the first corner to a center of the light-emitting region is greater than a distance from an intersection of two sides or extension lines of the two sides constituting the second corner to the center of the light-emitting region;
at least one of the first subpixel and the third subpixel comprises a first type subpixel and a second type subpixel; for different types of subpixels, directions from a vertex of the first corner to a vertex of the second corner are different; and in the first type subpixel and the second type subpixel, the directions from the vertex of the first corner to the vertex of the second corner direction are a first orientation and a second orientation, respectively, and the first orientation and the second orientation are opposite to each other.

16. The display substrate according to claim 15, wherein at least one of the first subpixel and the third subpixel further comprises a third type subpixel and a fourth type subpixel; for the third type subpixel and the fourth type subpixel, directions from the vertex of the first corner to the vertex of the second corner direction are a third orientation and a fourth orientation, respectively, the third orientation and the fourth orientation are opposite to each other, and the first orientation intersects with the third orientation.

17. The display substrate according to any one of claims 4-16, wherein at least one of the first subpixel and the third subpixel is a red subpixel configured to emit red light, the other one of the first subpixel and the third subpixel is a blue subpixel configured to emit blue light, and the second subpixel is a green subpixel configured to emit green light.

18. A display device, comprising a display substrate according to any one of claims 1-17.
